# EUROPEAN PATENT APPLICATION

(11) **EP 3 547 373 A1**
(43) Date of publication of application: **02.10.2019**
(21) Application number: 18731952.0
(22) Date of filing: 07.06.2018
(51) Int. Cl.: H01L 31/0445, H01L 31/0216

(54) **ZINC MAGNESIUM OXIDE MATERIAL, PREPARATION METHOD THEREFOR AND SOLAR CELL**

(30) Priority: 30.01.2018 CN 201810090928
(71) Applicant: Beijing Apollo Ding Rong Solar Technology Co., Ltd., Beijing 100176 (CN)
(72) Inventor: GUO, Lida, Beijing 100176 (CN); WANG, Lei, Beijing 100176 (CN); CHEN, Tao, Beijing 100176 (CN); LI, Xinlian, Beijing 100176 (CN); YANG, Lihong, Beijing 100176 (CN)
(74) Representative: Casalonga
(86) International application number: PCT/CN2018/090297
(87) International publication number: WO 2019/148731

(57) **Abstract**

A zinc magnesium oxide material includes at least two composite thin film layers. An atomic ratio of Zn element to Mg element in each of the at least two composite thin film layers is different from an atomic ratio of Zn element to Mg element in each of at least one remaining composite thin film layer of the at least two composite thin film layers.

## Description

This application claims priority to Chinese Patent Application No. 201810090928.1, filed on January 30, 2018, titled "A ZINC MAGNESIUM OXIDE MATERIAL WITH AN ADJUSTABLE OPEICAL BAND GAP, A METHOD FOR PRODUCING THE SAME AND A SOLAR CELL", which is incorporated herein by reference in its entirety.

### TECHNICAL FIELD

The present disclosure relates to the field of photovoltaic cells technologies, and more particularly, to a zinc magnesium oxide material, a method for producing the same and a solar cell.

### BACKGROUND

Copper Indium Gallium Selenium (CIGS) thin film solar cells have characteristics of low production cost, low pollution, no degradation, good weak light performance, and high photoelectric conversion rate. The CIGS thin film solar cell includes a buffer layer, and the material of the buffer layer is (Zn, Mg)O material.

### SUMMARY

Some embodiments of the present disclosure provides a zinc magnesium oxide material, comprising at least two composite thin film layers, wherein, an atomic ratio of Zn element to Mg element in each of the at least two composite thin film layers is different from an atomic ratio of Zn element to Mg element in each of at least one remaining composite thin film layer of the at least two composite thin film layers.

In accordance with some embodiments, the zinc magnesium oxide material is a composite material with a gradual changing optical band gap, and is a zinc magnesium oxide material with an adjustable optical band gap.

In accordance with some embodiments, the atomic ratio of Zn element to Mg element ranges from 1:1 to 20:1.

In accordance with some embodiments, along an incident direction of photons, atomic ratios of Zn element to Mg element in the at least two composite thin film layers gradually increase and band gaps of the at least two composite thin film layers gradually decrease.

In accordance with some embodiments, the Zn element comes from a zinc-containing compound.

In accordance with some embodiments, the zinc-containing compound is diethyl zinc.

In accordance with some embodiments, the Mg element comes from a magnesium-containing compound.

In accordance with some embodiments, the magnesium-containing compound is bis(cyclopentadienyl)magnesium.

Some embodiments of the present disclosure provides a method for producing the zinc magnesium oxide material, comprising: producing a ZnMgO material by using three precursors; and depositing at least two composite thin film layers on a substrate in sequence, wherein, atomic ratios of Zn element to Mg element in the at least two composite thin film layers gradually decrease along a direction away from the substrate.

In accordance with some embodiments, before depositing the at least two composite thin film layers on the substrate in sequence, the method further comprises cleaning the substrate.

In accordance with some embodiments, deposing the at least two composite thin film layers on the substrate in sequence comprises: placing the substrate on a sample tray and placing the sample tray in an atomic layer deposition apparatus; and setting a deposition temperature, and depositing the at least two composite thin film layers on the substrate in sequence under the deposition temperature.

In accordance with some embodiments, the three precursors are diethyl zinc, bis(cyclopentadienyl)magnesium and water, respectively.

In accordance with some embodiments, the deposition temperature is 100°C to 250°C.

Some embodiments of the present disclosure provide a solar cell comprising a buffer layer, and the buffer layer comprises the aforementioned zinc magnesium oxide material.

### BRIEF DESCRIPTION OF THE DRAWINGS

The accompanying drawings described herein are used to provide further understanding to the disclosure and constitute a part of the disclosure. The exemplary embodiments of the disclosure and the description thereof are used to explain the disclosure, but do not constitute an improper limitation to the disclosure. In the accompanying drawings:
Fig. 1 is a cross section diagram of a zinc magnesium oxide material according to some embodiments of the present disclosure;
Fig. 2 is a performance change diagram of a zinc magnesium oxide material along an incident direction of photons according to some embodiments of the present disclosure;
Fig. 3 is a performance change diagram of a zinc magnesium oxide material along an incident direction of photons according to some other embodiments of the present disclosure;
Fig. 4 is a production method of a composite thin film layer according to some embodiments of the present disclosure; and
Fig. 5 is a structure of a solar cell according to some embodiments of the present disclosure.

### DETAILED DESCRIPTION

The technical solutions of the present disclosure will be described below in detail through embodiments. The following embodiments are only for illustration and explanation of the disclosure, but not for limitation to the disclosure.

Some embodiments of the present disclosure provide a buffer layer material used in a Copper Indium Gallium Selenium thin film solar cell. The buffer layer material is a zinc magnesium oxide (ZnMgO) material, and the zinc magnesium oxide material is a composite material with a gradual changing optical band gap. The optical band gap is defined as a photon energy corresponding to an absorption coefficient of 10³ or 10⁴ cm⁻¹. The zinc magnesium oxide material is a thin film material composed of Zn element, Mg element, and O element, and the thin film material has a large width of forbidden band. Therefore, when the buffer layer material of the CIGS thin film battery is the zinc magnesium oxide material, visible light penetrates the buffer layer and reaches to an absorption layer, so that a quantum efficiency of the solar cell is increased.

In some embodiments of the present disclosure, the zinc magnesium oxide material includes two or more composite thin film layers, that is, at least two composite thin film layers.

In some embodiments of the present disclosure, each of the at least two composite thin film layers is produced with different atomic ratios of Zn element to Mg element. That is, the atomic ratio of Zn element to Mg element in each of the at least two composite thin film layers is different from an atomic ratio of Zn element to Mg element in each of at least one remaining composite thin film layer of the at least two composite thin film layers.

Exemplary, the zinc magnesium oxide material includes three composite thin film layers, and the atomic ratios of Zn element to Mg element in each of the composite thin film layers are 4:1, 6:1 and 9:1, respectively. Exemplary, the zinc magnesium oxide material includes four composite thin film layers, and the atomic ratios of Zn element to Mg element in each of the composite thin film layers are 4:1, 6:1, 7:1 and 9:1, respectively.

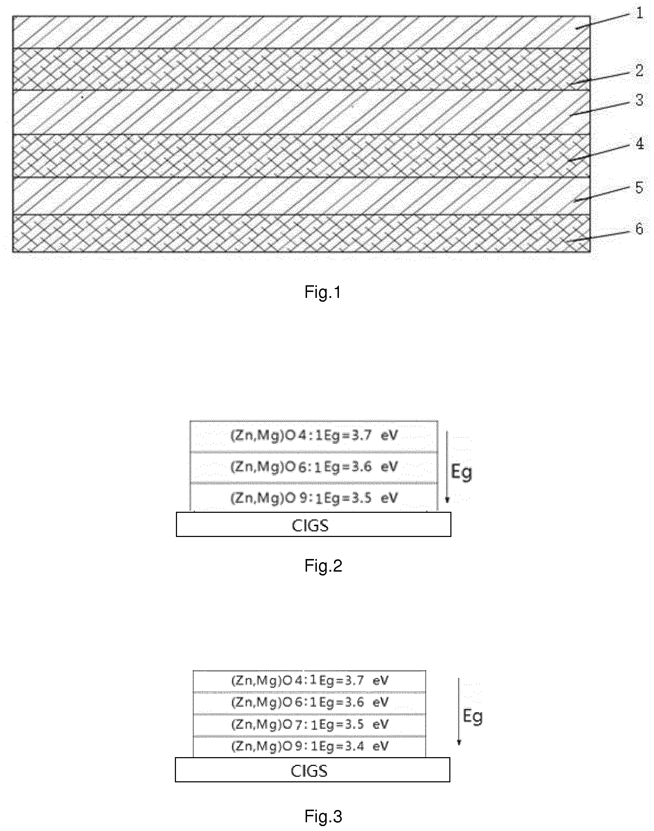

In some embodiments of the present disclosure, as shown in Fig. 1, the zinc magnesium oxide material includes six composite thin film layers, that is, a first composite thin film layer 1, a second composite thin film layer 2, a third composite thin film layer 3, a fourth composite thin film layer 4, a fifth composite thin film layer 5, and a sixth composite thin film layer 6, and the atomic ratios of Zn element to Mg element in each of the composite thin film layers are 4:1, 6:1, 7:1, 9:1, 11:1 and 14:1, respectively. In some other embodiments of the present disclosure, the atomic ratios of Zn element to Mg element in the at least two composite thin film layers are determined based on actual needs.

The Zn element comes from a zinc-containing compound. In some embodiments of the present disclosure, the zinc-containing compound is dimethylzinc, zinc chloride, etc. In some other embodiments of the present disclosure, the zinc-containing compound is diethyl zinc. Since the diethyl zinc has a suitable saturated vapor pressure at a lower temperature, the diethyl zinc has a lower deposition temperature, thereby facilitating the deposition of the composite thin film layer.

The Mg element comes from a magnesium-containing compound. In some embodiments of the present disclosure, the magnesium-containing compound is bis(ethylcyclopentadienyl)magnesium (Mg(CpEt)₂), etc. In some other embodiments of the present disclosure, the magnesium-containing compound is bis(cyclopentadienyl)magnesium. Since the bis(cyclopentadienyl)magnesium has a suitable saturated vapor pressure at a lower temperature, the bis(cyclopentadienyl)magnesium has a lower deposition temperature, and can be used to be performed an Atomic Layer Deposition (ALD).

A person skilled in the art can select the range of the atomic ratios of Zn element to Mg element according to actual needs. In some embodiments of the present disclosure, the atomic ratio of Zn element to Mg element ranges from1:1 to 20:1, such as 1:1, 4:1, 6:1, 7:1, 9:1, 12:1, 15:1 or 20:1. When the atomic ratio of Zn element to Mg element is in the range of 1:1 to 20:1, the band gap of the composite thin film layer formed matches with that of each of other layers of the solar cell well. If contents of the Mg element in the composite thin film layer are small, the zinc magnesium oxide material formed will has a poor conductivity. If contents of the Mg element in the composite thin film layer are large, the zinc magnesium oxide material formed will lose its semiconductor property. It will be noted that the atomic ratios outside this range can also be used to produce the buffer layer material.

In some embodiments of the present disclosure, as shown in Figs. 2 and 3, when the zinc magnesium oxide material is used in a Copper Indium Gallium Selenium thin film solar cell, the atomic ratios of Zn element to Mg element in the at least two composite thin film layers gradually increase along the incident direction of photons, so that the optical band gap Eg of each of the at least two composite thin film layers gradually decreases. Therefore, photon energy over the entire wavelength range (E>Eg(CIGS)) is facilitated to be absorbed. Meanwhile, the refractive index of each of the at least two composite thin film layers gradually increases along the incident direction of photons, and thus photon reflection is effectively reduced, so that photon absorption efficiency is improved.

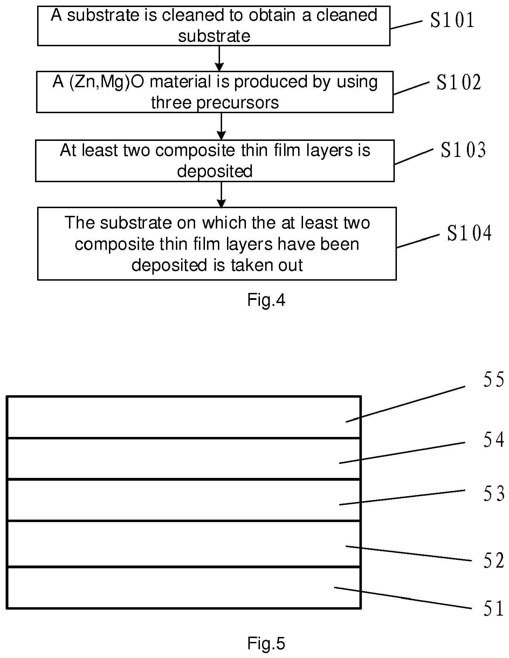

Some embodiments of the present disclosure further provide a method for producing the zinc magnesium oxide material. As shown in Fig. 4, the method includes: producing a (Zn,Mg)O material by using three precursors, and depositing at least two composite thin film layers on a substrate in sequence. Atomic ratios of Zn element to Mg element in the at least two composite thin film layers gradually decrease along a direction away from the substrate.

In some embodiments of the present disclosure, the three precursors are diethyl zinc, bis(cyclopentadienyl)magnesium and water, respectively.

In some embodiments of the present disclosure, the substrate is a CIGS layer.

In some embodiments of the present disclosure, before depositing the at least two composite thin film layers on the substrate in sequence, the method further includes cleaning the substrate.

In some embodiments of the present disclosure, depositing the at least two composite thin film layers on the substrate in sequence includes: placing the substrate on a sample tray and placing the sample tray in an atomic layer deposition apparatus. In addition, the method further includes: setting a deposition temperature, and depositing the at least two composite thin film layers on the substrate in sequence under the deposition temperature.

Exemplary, the method for producing the zinc magnesium oxide material includes steps 101-104 (S101-S104).

In step 101 (S101), a substrate is cleaned to obtain a cleaned substrate.

In step 102 (S102), a (Zn, Mg)O material is produced by using three precursors. Zn element comes from diethyl zinc, Mg element comes from bis(cyclopentadienyl)magnesium, and O element comes from water.

In step 103 (S103), the cleaned substrate is placed on a sample tray, the sample tray is placed in an atomic layer deposition apparatus, and a deposition temperature is set to deposit at least two composite thin film layers.

In step 104 (S104), the substrate on which the at least two composite thin film layers have been deposited is taken out.

In some embodiments of the present disclosure, the deposition temperature is in a range of 100°C to 250°C.

In some embodiments of the present disclosure, as shown in Fig. 2, the zinc magnesium oxide material includes three composite thin film layers. The S103, depositing at least two composite thin film layers, includes steps 1031-1033 (S1031-S1033).

In step 1031 (S1031), an atomic layer deposition apparatus sprays a diethyl zinc steam once to a substrate on a sample tray, and then sprays water steam once, so that the diethyl zinc steam reacts with the water steam on the substrate and thus a first zinc oxide layer (with a thickness of one atomic layer in the thickness direction theoretically) is deposited. In turn, the above method for forming the zinc oxide layer is repeated eight times, and total nine zinc oxide layers are deposited on the substrate. Afterwards, the atomic layer deposition apparatus sprays the bis(cyclopentadienyl)magnesium steam once onto the ninth zinc oxide layers, and then sprays the water steam once, so that the bis(cyclopentadienyl)magnesium steam reacts with the water steam on the ninth zinc oxide layer and thus one magnesium oxide layer (with a thickness of one atomic layer in the thickness direction theoretically) is deposited. At this point, the deposition of a first composite thin film layer is finished, and the atomic ratio of Zn element to Mg element in the first composite thin film layer is 9:1.

In step 1032 (S1032), according to the method for forming the zinc oxide layer in S1031, total six zinc oxide layers are deposited on the first composite thin film layer. Afterwards, the bis(cyclopentadienyl)magnesium steam is sprayed once on the sixth zinc oxide layer, and the water steam is sprayed once, so that the bis(cyclopentadienyl)magnesium steam reacts with the water steam on the ninth zinc oxide layer and thus one magnesium oxide layer is deposited. At this point, the deposition of a second composite thin film layer is finished, and the atomic ratio of Zn element to Mg element in the second composite thin film layer is 6:1.

In step (S1033), according to the method for forming the zinc oxide layer in S1031, total four zinc oxide layers are deposited on the second composite thin film layer. Then the bis(cyclopentadienyl)magnesium steam is sprayed once on the fourth zinc oxide layer, and the water steam is sprayed once, so that the bis(cyclopentadienyl)magnesium steam reacts with the water steam on the ninth zinc oxide layer and thus one magnesium oxide layer is deposited. At this point, the deposition of a third composite thin film layer is finished, and the atomic ratio of Zn element to Mg element in the third composite thin film layer is 4:1.

In some embodiments of the present disclosure, as shown in Fig. 3, the deposition of four composite thin film layers is finished in sequence according to the S103.

After taking out the substrate on which the composite thin film layers have been deposited, morphology of the substrate is characterized by a Scanning Electron Microscope (SEM) to observe compactness and a surface morphology structure of the composite thin film layers. The atomic ratio of Zn to Mg in the substrate is detected by an Energy Dispersive Spectrometer (EDS), and the light transmittance of the composite thin film layers is tested by a spectrophotometer, so as to calculate the optical band gap of the composite thin film layers.

In some embodiments of the present disclosure, a multilayer composite film with different Zn/Mg atomic ratios is produced by adjusting the atomic ratio of Zn to Mg, and the multilayer composite film may realize continuous adjustment of optical band gap of the thin film.

Some embodiments of the present disclosure provide a solar cell. As shown in Fig. 5, the solar cell includes a substrate 51, a back electrode layer 52, a CIGS absorbing layer 53, a buffer layer 54 and a transparent conducting layer 55. The material of the buffer layer 54 in the solar cell includes the aforementioned zinc magnesium oxide material.

The buffer layer and the absorbing layer in the solar cell form a pn junction, which is used as a working area of the thin film solar cell, so that the light energy is converted into electrical energy. Since the aforementioned zinc magnesium oxide material includes at least two composite thin film layers, and the atomic ratio of Zn element to Mg element in each of the at least two composite thin film layers is different from an atomic ratio of Zn element to Mg element in each of at least one remaining composite thin film layer in the at least two composite thin film layers, the buffer layer including the aforementioned zinc magnesium oxide material and the absorbing layer have a good match in energy band. Therefore, a good pn junction is formed, and the electrical leakage of the device is avoided. Therefore, the solar cell has a higher open circuit voltage, better fill factor and higher conversion efficiency.

Although some embodiments of the present disclosure have been shown and described, it will be apparent to those skilled in the art that various changes, modifications, amendments and variants can be made to these embodiments without departing from the principles and spirits of the present disclosure, and the scope of the disclosure is defined by the accompanying claims and their equivalents.

## Claims

1. A zinc magnesium oxide material comprising at least two composite thin film layers, wherein,
an atomic ratio of Zn element to Mg element in each of the at least two composite thin film layers is different from an atomic ratio of Zn element to Mg element in each of at least one remaining composite thin film layer of the at least two composite thin film layers.

2. The zinc magnesium oxide material according to claim 1, wherein, the zinc magnesium oxide material is a composite material with a gradual changing optical band gap, and is a zinc magnesium oxide material with an adjustable optical band gap.

3. The zinc magnesium oxide material according to claim 2, wherein, the atomic ratio of Zn element to Mg element ranges from 1:1 to 20:1.

4. The zinc magnesium oxide material according to claim 2, wherein, along an incident direction of photons, atomic ratios of Zn element to Mg element in the at least two composite thin film layers gradually increase and band gaps of the at least two composite thin film layers gradually decrease.

5. The zinc magnesium oxide material according to claim 2, wherein, the Zn element comes from a zinc-containing compound.

6. The zinc magnesium oxide material according to claim 5, wherein, the zinc-containing compound is diethyl zinc.

7. The zinc magnesium oxide material according to claim 2, wherein, the Mg element comes from a magnesium-containing compound.

8. The zinc magnesium oxide material according to claim 7, wherein, the magnesium-containing compound is bis(cyclopentadienyl)magnesium.

9. A method for producing the zinc magnesium oxide material according to any one of claims 1-8, comprising:
producing a ZnMgO material by using three precursors; and
depositing at least two composite thin film layers on a substrate in sequence, wherein, atomic ratios of Zn element to Mg element in the at least two composite thin film layers gradually decrease along a direction away from the substrate.

10. The method according to claim 9, comprising: before depositing the at least two composite thin film layers on the substrate in sequence,
cleaning the substrate.

11. The method according to claim 10, wherein, depositing the at least two composite thin film layers on the substrate in sequence, comprises:
placing the substrate on a sample tray and placing the sample tray in an atomic layer deposition apparatus; and
setting a deposition temperature, and depositing at least two composite thin film layers on the substrate in sequence under the deposition temperature.

12. The method according to claim 11, wherein, the three precursors are diethyl zinc, bis(cyclopentadienyl)magnesium and water, respectively.

13. The method according to claim 11, wherein, the deposition temperature ranges from 100°C to 250°C.

14. A solar cell comprising a buffer layer, wherein the buffer layer comprises the zinc magnesium oxide material according to any one of claims 1-8.
